# FASCICULE DE BREVET EUROPEEN

(11) **EP 0 410 856 B1**
(45) Date de publication et mention de la délivrance du brevet: **08.05.1996**
(21) Numéro de dépôt: 90402095.5
(22) Date de dépôt: 20.07.1990
(51) Int. Cl.: G01R 33/30

(54) **Turbine à rotor animé d'un mouvement de nutation et de précession**
Turbine mit einem eine Nutations- und Präzessionsbewegung ausführenden Rotor
Turbine with nutating and precessing rotor

(30) Priorité: 24.07.1989 FR 8909937
(43) Date de publication de la demande: 30.01.1991
(73) Titulaire: COMMISSARIAT A L'ENERGIE ATOMIQUE, F-75015 Paris Cédex 15 (FR)
(72) Inventeur: Llor, Antoine, F-92100 Boulogne (FR)
(74) Mandataire: Dubois-Chabert, Guy

(56) Documents cités:
- US-A- 4 510 450
- MOLECULAR PHYSICS, vol. 65, no. 4, 1988, pages 1013-1018; A. SAMOSON et al.: "High resolution solid-state N.M.R. Averaging of second-order effects by means of a double-rotor"

## Description

La présente invention se rapporte à une turbine dont le rotor est animé d'un mouvement double de nutation et de précession et qui est normalement destinée à l'analyse d'échantillons solides et notamment pulvérulents par résonance magnétique nucléaire.

Cette méthode d'analyse est largement utilisée depuis quelques dizaines d'années pour des analyses spectroscopiques d'échantillons liquides, mais son application est plus difficile pour des échantillons solides car l'absence de mouvement brownien nuit à la qualité des résultats.

On a déjà eu l'idée de simuler un mouvement brownien en enfermant l'échantillon solide dans le rotor d'une turbine soumise à un mouvement de rotation rapide. Le rotor est disposé dans un volume entouré par une bobine de réception des signaux de mesure. Mais cette méthode n'est pas entièrement satisfaisante car elle n'est efficace que pour des noyaux de spin égal à 1/2, alors qu'on préférerait souvent disposer d'informations de bonne qualité sur des noyaux de spin supérieurs à ce nombre, tels que ¹⁷O, ³Na, ⁷Al, etc. Même sur les noyaux de spin égal à 1/2, les hétérogénéités de permittivité magnétique dues par exemple aux interstices entre grains dans la poudre de l'échantillon limitent la résolution que l'on peut espérer.

On a proposé une amélioration à ce procédé en faisant tourner le rotor selon un double mouvement de nutation et de précession : le rotor tourne sur lui-même autour d'un axe de nutation qui est quant à lui tourné suivant un mouvement de précession de façon à décrire un cône d'axe fixe. On appelle ω₁ la vitesse de rotation du mouvement de précession et ω₂ celle du mouvement de nutation, θ₁ l'angle entre la direction du champ magnétique et l'axe fixe, et θ₂ l'angle de demi-ouverture du cône. Les conditions théoriques auxquelles les réalisations concrètes doivent obéir ont été dégagées. C'est ainsi que les angles θ₁ et θ₂ doivent être choisis parmi les quatre couples de valeurs suivantes :
θ₁ = 54,74°, θ₂ = 30,56° ;
θ₁ = 54,74°, θ₂ = 70,12° ;
θ₁ = 30,56°, θ₂ = 54,74° ; et enfin
θ₁ = 70,12°, θ₂ = 54,74°.

La première solution est toutefois préférable car elle implique un angle de précession minimal et simplifie donc la réalisation. Les vitesses de précession ω₁ et de nutation ω₂ doivent être commensurables à environ 10⁻³ près, mais dans un rapport différent de 4, 3, 2, 3/2, 4/3, 1 ou leurs inverses ; leur plus grand commun diviseur doit cependant être plus élevé que l'interaction magnétique à supprimer, ce qui amène à choisir des rapports égaux à par exemple 5, 5/2, 5/3, 5/4 et leurs inverses, le rapport des vitesses étant cependant de préférence proche de l'unité.

La vitesse de rotation du rotor doit enfin être de plusieurs kilohertz afin de supprimer l'interaction magnétique, et les matériaux conducteurs sont proscrits au voisinage de la bobine de réception.

La Communication préliminaire parue dans Molecular Physics, 1988, Vol. 65, n^{o} 4, pages 1013 à 1018, par Samoson, Lippmaa et Pines, décrit ainsi très schématiquement une turbine à double rotor dans laquelle le rotor contenant l'échantillon tourne dans un rotor externe de taille beaucoup plus importante et les axes de rotation des deux rotors sont distincts de l'angle de précession.

On peut reprocher plusieurs inconvénients à cette solution. En particulier, l'équilibrage dynamique de l'ensemble n'est pas facile à respecter, pas plus que l'alimentation en gaz permettant d'entraîner le rotor interne. Il n'est ensuite pas évident de respecter un rapport des vitesses de nutation et de précession admissible, car les entraînements des deux rotors utilisent deux circuits gazeux indépendants et les mesures de la vitesse de rotation du rotor interne ne sont pas faciles. Enfin le facteur de remplissage, c'est-à-dire le rapport entre le volume de l'échantillon à analyser et le volume que la bobine de réception entoure, est très faible avec ce dispositif car le rapport ω₂/ω₁ vaut 5 et l'équilibrage dynamique du rotor donne dans ces conditions une chambre très allongée (rapport longueur/diamètre de l'ordre de 3).

L'invention représente une solution pour éviter ces divers inconvénients et concerne une turbine de fonctionnement simple et qui ne fait pas appel à des éléments technologiques compliqués.

Elle comprend un stator, un rotor muni d'ailettes ou d'entailles d'entraînement et disposé sur des paliers fluides à l'intérieur du stator, des systèmes de soufflage de gaz pour alimenter les paliers et entraîner les ailettes et le rotor pour faire rouler ce dernier sans glisser sur le stator, mais ici le rotor est unique et soumis à la fois aux mouvements de nutation et de précession. Il se compose d'un noyau central, généralement limité par des portions de sphères concentriques, muni d'une cavité contenant l'échantillon à analyser et de deux surfaces de roulement généralement coniques, coaxiales en prolongement de part et d'autre du noyau et de sommets confondus avec le centre du noyau ; le stator est quant à lui composé de deux surfaces d'appui de forme généralement conique sur lesquelles le rotor roule par ses surfaces de roulement. Les cônes définissant ces surfaces d'appui ont un même axe faisant un angle aigu avec l'axe des surfaces de roulement. Avec cette conception, le noyau a une surface constituée d'au moins une portion sphérique, une portion sphérique étant de toute façon associée à chaque palier.

Le noyau peut soit être muni de concavités délimitées par les surfaces de roulement, soit porter deux rouleaux généralement coniques dont une paroi constitue une surface de roulement. Les ailettes ou les entailles sont alors situées sur les rouleaux, notamment à leur extrémité opposée au noyau.

Le noyau peut être soit parfaitement sphérique, soit par exemple formé de deux calottes sphériques, auxquelles se raccordent respectivement le cas échéant les deux rouleaux, ainsi que d'une sphère tronquée entre les deux calottes. Cette solution peut être employée dans le cas courant où les paliers sont constitués d'un palier annulaire formé d'orifices de soufflage répartis sur une circonférence du stator entre les surfaces d'appui et d'un palier de butée constitué de deux orifices de soufflage disposés chacun suivant l'axe d'une des surfaces d'appui.

La cavité peut être cylindrique et d'axe confondu avec l'axe des rouleaux.

On va maintenant décrire l'invention plus en détail à l'aide des figures suivantes illustrant une réalisation de l'invention, annexées à titre illustratif et non limitatif :
- la figure 1 est une coupe diamétrale de la turbine ;
- la figure 2 est une vue agrandie d'un orifice de soufflage suivant la ligne II-II de la figure 1 ;
- la figure 3 est une coupe suivant la ligne III-III de la figure 2 ;
- la figure 4 est une vue agrandie d'un orifice de soufflage prise en coupe suivant la ligne IV-IV de la figure 1 ;
- la figure 5 représente, vu de côté, le système d'entraînement du rotor ;
- les figures 6 et 7 représentent deux réalisations du rotor ;
- la figure 8 représente une possibilité concrète de fabrication du rotor avec sa cavité ; et
- la figure 9 représente une autre conception de la turbine.

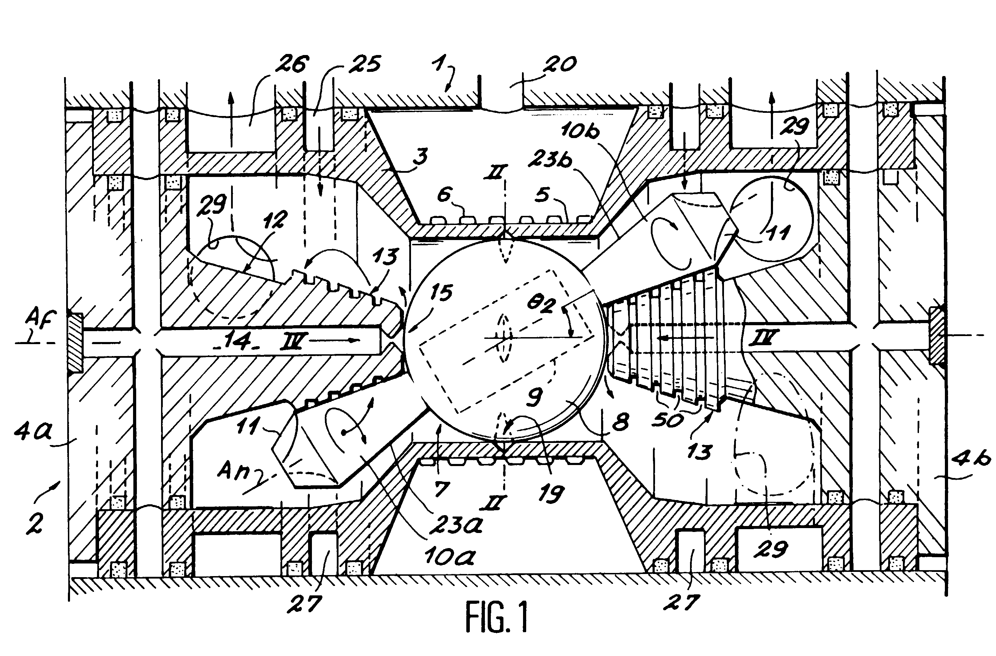

On remarque sur la figure 1 que la turbine est constituée d'un corps principal 1 muni d'un évidement cylindrique dans lequel débouchent divers circuits d'alimentation et d'évacuation d'air comprimé. L'évidement cylindrique loge un stator 2 constitué par une partie médiane 3 à laquelle sont raccordées deux parties d'extrémité 4a et 4b. La partie médiane 3 comprend une zone rétrécie 5 centrale, formée d'une paroi de faible épaisseur autour de laquelle est enroulée une bobine de radiofréquences 6 pour recevoir des signaux de mesure.

Le rotor 7 est disposé de l'autre côté de cette paroi de zone rétrécie 5. Il se compose d'un noyau central 8 sphérique et dans lequel on a creusé une cavité 9 cylindrique, ainsi que de deux rouleaux 10a et 10b coniques qui s'ouvrent légèrement en s'éloignant du noyau central 8. Les rouleaux 10a et 10b se raccordent au noyau central 8 en deux endroits opposés de celui-ci et s'étendent suivant l'axe Aₙ qui correspond à l'axe de nutation du rotor 7 et qui est d'ailleurs confondu avec l'axe de la cavité 9 cylindrique.

Les extrémités des rouleaux 10 opposées au rotor 7 sont munies d'entailles 11 qui délimitent et séparent des ailettes d'entraînement et qui se succèdent suivant deux circonférences autour de l'axe de nutation Aₙ.

Chacune des parties d'extrémité 4 comprend une excroissance 12 qui s'étend à l'intérieur de la partie médiane 3 en direction du rotor 7 et qui se termine par une surface d'appui 13 conique sur laquelle un rouleau respectif 10a, 10b vient rouler par une surface de roulement conique 23a ou 23b.

Les surfaces d'appui 13 sont définies par des cones d'axe commun A_{f} ou axe fixe qui fait avec l'axe de nutation Aₙ un angle de précession ϑ₂ égal à 30,56°. L'angle non représenté ϑ₁ que fait l'axe fixe A_{f} avec la direction du champ magnétique est égal à 54,74°. Le demi-angle d'ouverture des cônes des rouleaux 10 est égal à 11,37° dans le cas d'un rapport ω₂/ω₁ =5/3. Le rotor peut alors rouler sans glisser.

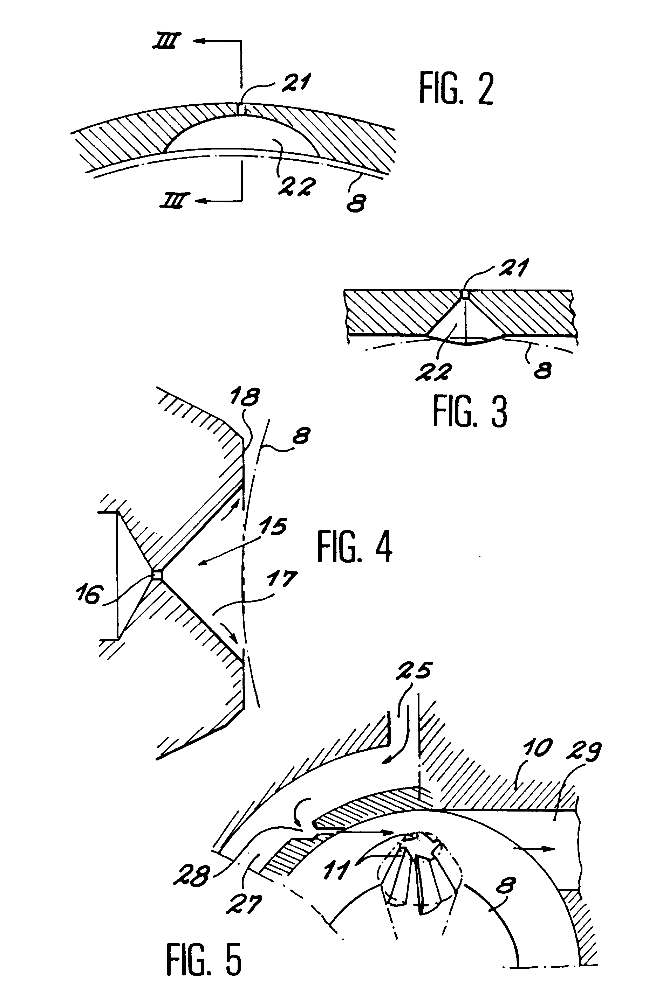

Des circuits d'alimentation en air comprimé s'étendent dans le corps principal 1 et les parties d'extrémité 4 en passant par la partie médiane 3. Ces circuits comprennent, dans chaque partie d'extrémité 4, un conduit d'alimentation 14 le long de l'axe fixe A_{f} qui débouche sur un ajutage 15 ; l'ajutage 15, représenté figure 4, comprend un orifice 16 et une chambre conique 17 qui s'élargit en direction du noyau central 8, devant lequel elle aboutit de façon à constituer une butée aérodynamique de bonne portance. Les excroissances 12 sont donc munies, autour de la chambre conique 17, d'une face d'arrêt 18 définie de sorte que, quand le stator 2 est assemblé, il ne subsiste qu'un très léger jeu entre le noyau central 8 et les deux faces d'arrêt 18.

Un second circuit d'alimentation 20 débouche du corps principal 1 dans l'espace annulaire qui entoure la paroi de zone rétrécie 5. Cette paroi est percée à mi-distance longitudinale, devant le centre du noyau central 8, d'ajutages 19 répartis suivant une circonférence de façon à constituer un palier annulaire. Les ajutages 19 sont constitués, comme le représentent les figures 2 et 3, d'un orifice 21 qui débouche sur une chambre élargie 22, devant le noyau central 8, dont la section est triangulaire d'ouverture réduite suivant le sens longitudinal du stator 2 mais s'ouvre davantage, avec un contour en arc de cercle, en direction circonférentielle.

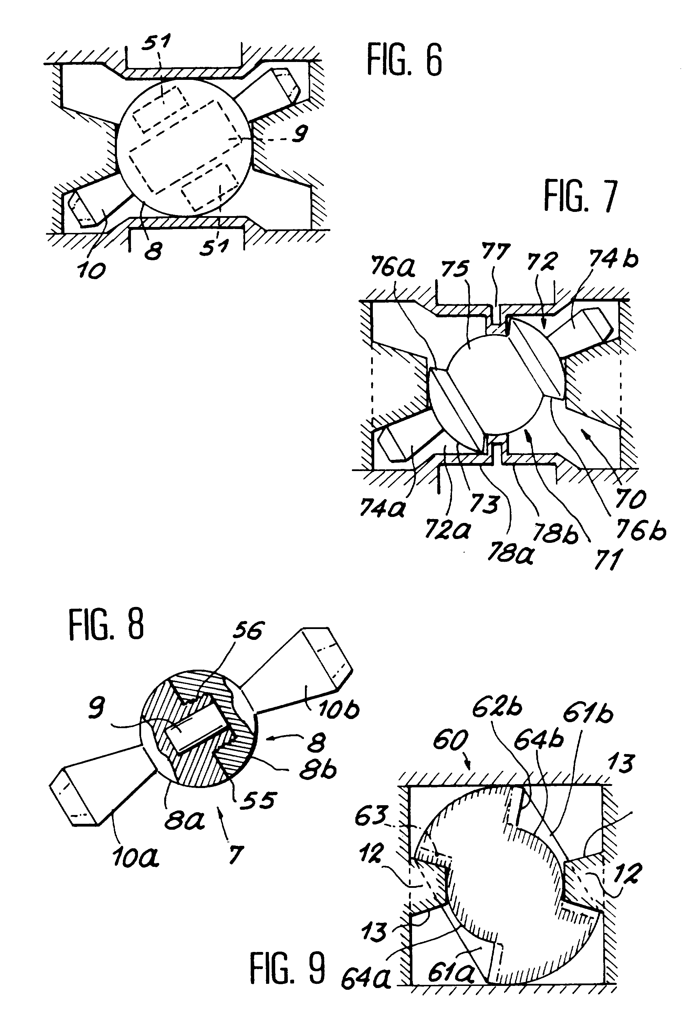

Cette disposition, où l'on peut distinguer deux paliers aérodynamiques distincts, permet d'utiliser des noyaux centraux de forme plus compliquée telle que celle représentée sur la figure 7, où le rotor 70 comprend un noyau central 71 constitué de deux calottes sphériques 72a, 72b sur la surface sphérique externe 73a, 73b desquelles s'élèvent respectivement les rouleaux 74a et 74b, ainsi que d'une sphère tronquée 75 raccordée aux calottes sphériques 72a et 72b par un raccordement conique 76a, 76b. Les surfaces sphériques du noyau central 71 sont centrées au même point, ce qui fait que les rotations du rotor 70 amènent toujours la surface externe 73 des calottes sphériques 72 devant un des ajutages 15 situé sur les parties extrêmes 4 alors que la surface de la sphère tronquée 75 reste devant les ajutages 19 répartis sur la circonférence de la paroi de la zone rétrécie 5. Cette dernière est alors modifiée par rapport à la figure 1 pour comprendre une bague centrale 77 mitoyenne de deux parties cylindriques en prolongement 78a, 78b de plus grand diamètre. Les ajutages 19 sont placés sur la bague 77. On peut ainsi réduire les contraintes que subit le rotor du fait du mouvement, et qui limitent le plus souvent la vitesse de rotation accessible.

La pression dans la cavité balayée par les extrémités du rotor est réduite à moins d'un centième de bar par un système de pompage adapté. On diminue ainsi la traînée aérodynamique qui autrement limiterait considérablement la vitesse de rotation.

Le dimensionnement des paliers est régi par les lois d'écoulement des gaz. Comme l'espace dans lequel le rotor 7 tourne est à basse pression, le régime est purement supersonique et les forces d'inertie prédominent sur les forces de viscosité. L'inventeur préconise, afin d'obtenir une bonne stabilité des paliers, de rechercher une pression s'exerçant sur le rotor 7 au niveau des paliers qui soit égale au quart de la pression dans les circuits d'alimentation. Les chambres 17 et 22 sont alors dimensionnées de sorte que la surface d'écoulement des gaz entre le stator 2 et le rotor 7 (ce dernier étant supposé parfaitement centré) soit quatre fois plus grande que la section des orifices respectifs 16 et 21. Les chambres 17 et 22 sont par ailleurs au moins trois fois plus profondes que les diamètres des orifices respectifs 16 et 21 afin d'y confiner l'onde de choc.

Les figures 1 et 5 montrent que l'entraînement du rotor 7 au moyen des entailles 11 s'effectue à l'aide d'un autre circuit d'alimentation de gaz formé de conduites d'alimentation 25 et de conduites d'évacuation 26 établies dans le corps principal 1, parallèles entre elles et adjacentes. Les conduites d'alimentation 25 sont au nombre de deux, une pour chaque rouleau 10 ; elles se terminent chacune par une partie annulaire 27 autour de la partie médiane 3 du stator 2 et qui communique avec l'intérieur du stator 2 au moyen de trois orifices de soufflage 28 espacés angulairement de 120°. L'équilibrage correct du rotor 7 impose de toujours exercer le même entraînement sur chacun des rouleaux 10a, 10b, ce qui implique que les orifices de soufflage 28 du côté du rouleau 10b sont décalés angulairement de 60° par rapport à ceux du côté du rouleau 10a.

Le diamètre des orifices de soufflage 28 est déterminé pour que les ondes de choc des jets libres qu'elles créent se développent le plus près possible (voire à l'intérieur) d'orifices de pompage 29 qui sont percés à travers la partie médiane 3, sensiblement en face des orifices de soufflage 28, pour recueillir et évacuer les gaz soufflés sur les entailles 11 et dans les paliers par les conduites d'évacuation 26. Un système de pompage, branché sur l'extrémité extérieure des conduites d'évacuation 26, instaure le vide ou une basse pression dans le stator 2.

Des joints annulaires non référencés assurent bien entendu l'étanchéité entre les différentes parties assemblées et les différents conduits.

Les matériaux qui constituent le rotor 7 et le stator 2 doivent être non conducteurs de l'électricité et suffisamment résistants. C'est pourquoi on prévoit qu'ils seront normalement de la céramique. Les surfaces du rotor 7 utilisées pour le roulement ou le contact avec un palier à gaz seront recouvertes de graphite ou d'un autre lubrifiant solide, ce qui permet de protéger le rotor 7 contre les instabilités, génératrices de chocs, au début du fonctionnement.

Les surfaces d'appui 13 sont entaillées de gorges circonférentielles 50 qui permettent d'écouler les gaz qui auraient pu s'interposer entre les surfaces coniques roulant l'une sur l'autre et former des couches continues.

Les caractéristiques géométriques idéales du rotor 7 sont celles pour lesquelles le mouvement combiné de nutation et précession auquel il est soumis correspond à un mouvement gyroscopique naturel du rotor 7, où le roulement ne produit théoriquement pas de contraintes. Il est toutefois nécessaire en pratique de laisser subsister un léger déséquilibre pour être certain de maintenir un effort de contact entre les rouleaux 10 sur les surfaces d'appui 13.

Comme les contraintes mécaniques à la racine des rouleaux 10 sont alors facilement très importantes, le noyau central 8 peut favorablement être évidé à sa périphérie, comme le représente la figure 7, ou encore, comme le représente la figure 6, en le creusant d'évidements 51 disposés symétriquement autour de la cavité 9 et en forme de cylindres dont les axes sont parallèles à l'axe de nutation Aₙ.

La figure 8 représente plus en détail un rotor 7 du point de vue de sa fabrication. Le noyau central 8 est en fait composé de deux demi-sphères 8a et 8b jointes en un plan de joint 55 orthogonal à l'axe de nutation Aₙ et à mi-distance des rouleaux 10.

Une demi-sphère 8a est munie d'un manchon cylindrique central 56 qui entoure la cavité 9 et dont la périphérie extérieure est filetée ; l'assemblage du rotor 7 s'effectue en vissant l'autre demi-sphère 8b sur le manchon cylindrique central 56 jusqu'à ce que les faces planes des demi-sphères 8a et 8b se touchent au plan de joint 55.

L'extérieur du rotor 7 est usiné après le premier assemblage afin d'obtenir une surface parfaitement lisse et une symétrie géométrique.

La figure 9 montre une autre réalisation de la turbine. Le rotor est ici référencé par 60 et consiste uniquement en un noyau central en forme de sphère munie de deux concavités diamétralement opposées 61a et 61b. Les concavités 61a et 61b sont délimitées chacune par une surface conique 62a ou 62b centrée sur l'axe de nutation An et par un fond en calotte sphérique 64a et 64b qui permet de conserver un palier de butée entre les excroissances 12. Chaque surface conique 62 roule sur une surface de roulement 13.

Cette turbine hypocloïdale est sujette à des limitations de vitesse de précession en fonction de la vitesse de nutation sous peine de compromettre l'adhérence des surfaces de roulement. Il est en outre nécessaire d'assurer l'entraînement du rotor 60 en établissant des entailles 63 sur une partie de la largeur des surfaces coniques 62. L'entraînement et l'évacuation des gaz sont dans ces conditions plus difficiles à assurer correctement. C'est pour ces diverses raisons que le rotor 7 à rouleaux 10 est sans doute préférable.

Le stator 2 n'est pas modifié dans ses grandes lignes par rapport aux réalisations précédentes sauf bien sûr en ce qui concerne le circuit d'alimentation en gaz d'entraînement, qui passe par les excroissances 12 et débouche par des orifices non représentés sur les surfaces de roulement 13.

D'autres réalisations équivalentes sont possibles sans sortir du cadre de l'invention. La turbine de la figure 1 représente un rotor dont le rapport entre les vitesses de rotations, de nutation et de précession est égal à 5/3. L'exposé des conditions théoriques qui a précédé la description détaillée de cette turbine montre que d'autres choix sont possibles, et la détermination des nouvelles conditions géométriques et mécaniques appropriées n'est qu'une affaire de routine pour le spécialiste.

La cavité contenant l'échantillon peut être de toute forme de révolution autour de l'axe de nutation Aₙ.

Quand une analyse sur un échantillon de poudre a été décidée, on conseille de soumettre le rotor à des mouvements de rotation autour de l'axe longitudinal puis d'un axe transversal, hors du stator, pour obtenir un tassage homogène dans la cavité.

## Revendications

1. Turbine destinée à l'analyse d'échantillons par résonance magnétique nucléaire, comprenant un stator (2), un rotor (7, 60, 70) muni d'entailles d'entraînement et disposé sur des paliers fluides (15, 19) à l'intérieur du stator, des systèmes de soufflage de gaz (28) pour alimenter les paliers et entraîner les entailles et le rotor, caractérisée en ce que le rotor se compose d'un noyau central (8, 61, 71) muni d'une cavité (9) contenant l'échantillon et de deux surfaces de roulement généralement coniques et coaxiales (23, 62) de part et d'autre du noyau, et en ce que le stator comprend deux surfaces d'appui des surfaces de roulement de forme généralement conique (13), les cônes définissant les surfaces d'appui ayant un même axe (A_{f}) faisant un angle aigu avec l'axe des surfaces de roulement, le noyau ayant une surface constituée d'une portion sphérique devant chaque palier.

2. Turbine selon la revendication 1, caractérisée en ce qu'elle comprend deux rouleaux (10) en prolongement de part et d'autre du noyau (8), sur lesquels les entailles (11) sont établies et qui possèdent chacun une paroi (23) correspondant à une des surfaces de roulement.

3. Turbine selon la revendication 1, caractérisée en ce que le noyau est muni de deux concavités (61) dont chacune est délimitée par une des surfaces de roulement (62).

4. Turbine selon l'une quelconque des revendications 1 à 3, caractérisée en ce que les paliers comprennent un palier annulaire constitué d'ajutages de soufflage (19) répartis sur une circonférence du stator (2) entre les surfaces d'appui (13) et d'un palier constitué de deux ajutages de soufflage (15) disposés chacun suivant l'axe (A_{f}) d'une des surfaces d'appui (13).

5. Turbine selon les revendications 2 et 4, caractérisée en ce que le noyau est constitué de deux calottes sphériques (72) situées chacune devant un des ajutages de soufflage (15) des surfaces d'appui et à chacune desquelles un rouleau (1u) se raccorde, ainsi que d'une sphère tronquée (75) unissant les deux calottes sphériques, de plus petit diamètre que celui des calottes sphériques et située devant le palier annulaire.

6. Turbine selon l'une quelconque des revendications 1 ou 2, caractérisée en ce que le noyau (8) est sphérique.

7. Turbine selon l'une quelconque des revendications 1 à 6, caractérisée en ce que la cavité (9) est un volume de révolution d'axe confondu avec l'axe des surfaces de roulement.

8. Turbine selon les revendications 6 et 7, caractérisée en ce que le noyau est évidé (51) autour de la cavité (9).

9. Turbine selon la revendication 2, caractérisée en ce que les entailles (11) sont situées aux extrémités des rouleaux (10) opposées au noyau.

10. Turbine selon l'une quelconque des revendications 1 à 9, caractérisée en ce que l'intérieur du stator est en dépression.

## Patentansprüche

1. Turbine bestimmt zur Analyse von Proben durch nukleare magnetische Resonanz, umfassend einen Stator (2), einen Rotor (7, 60, 70), versehen mit Antriebseinschnitten und angeordnet auf Fluid-Lagern (15, 19) im Innern des Stators, Gasblassysteme (28) um die Lager zu versorgen und die Einschnitte und den Rotor anzutreiben,
**dadurch gekennzeichnet,**
daß der Rotor gebildet wird durch einen zentralen Kern (8, 61, 71), versehen mit einem die Probe enthaltenden Hohlraum (9) und mit zwei allgemein konischen und koaxialen Wälzflächen (23, 62) beiderseits des Kerns, und dadurch, daß der Stator zwei Auflageflächen der Wälzflächen von allgemein konischer Form (13) umfaßt, wobei die die Auflageflächen definierenden Konusse dieselben Achse (A_{f}) haben und einen spitzen Winkel bilden mit der Achse der Wälzflächen und der Kern eine Oberfläche aufweist, die vor jedem Lager durch ein Kugelteilstück gebildet wird.

2. Turbine nach Anspruch 1, dadurch gekennzeichnet, daß sie beiderseits in Verlängerung des Kerns (8) zwei Walzen (10) umfaßt, an denen die Einschnitte (11) angebracht sind und von denen jede eine Wand (23) besitzt, einer der Wälzflächen entsprechend.

3. Turbine nach Anspruch 1, dadurch gekennzeichnet, daß der Kern mit zwei Hohlräumen (61) versehen ist, von denen jeder begrenzt ist durch eine der Wälzflächen (62).

4. Turbine nach einem der Ansprüche 1 bis 3, dadurch gekennzeichnet, daß die Lager ein ringförmiges Lager umfassen, gebildet durch Blasdüsen (19), verteilt über einen Umfang des Stators (2) zwischen den Auflageflächen (13), und ein Lager, gebildet durch zwei Blasdüsen (15), jede angeordnet in der Achse (A_{f}) von einer der Auflageflächen (13).

5. Turbine nach den Ansprüchen 2 und 4, dadurch gekennzeichnet, daß der Kern gebildet wird durch zwei Kugelkappen (72), jede angeordnet vor einer der Blasdüsen (15) der Auflageflächen und jede verbunden mit einer Walze (10) sowie mit einer abgestumpften Kugel (75), die die beiden Kugelkappen vereinigt und die einen kleineren Durchmesser aufweist als die Kugelkappen und sich vor dem ringförmigen Lager befindet.

6. Turbine nach einem der Ansprüche 1 oder 2, dadurch gekennzeichnet, daß der Kern (8) kugelförmig ist.

7. Turbine nach einem der Ansprüche 1 bis 6, dadurch gekennzeichnet, daß der Hohlraum (9) ein Rotationsvolumen ist, dessen Achse zusammenfällt mit der Achse der Wälzflächen.

8. Turbine nach den Ansprüchen 6 und 7, dadurch gekennzeichnet, daß der Kern um den Hohlraum (9) herum hohl ist (59).

9. Turbine nach Anspruch 2, dadurch gekennzeichnet, daß die Einschnitte (11) sich an den zum Kern entgegengesetzten Enden der Walzen (10) befinden.

10. Turbine nach einem der Ansprüche 1 bis 9, dadurch gekennzeichnet, daß im Innern des Stators Unterdruck herrscht.

## Claims

1. Turbine for the analysis of samples by nuclear magnetic resonance, comprising a stator (2), a rotor (7,60,70) provided with driving notches and located on fluid bearings (15,19) in the stator, gas blowing systems (28) for supplying the bearings and driving the notches and the rotor, characterized in that the rotor is constituted by a central core (8,61,71) provided with a cavity (9) containing sample and two generally conical, coaxial rolling surfaces (23,62) on either side of the core and in that the stator comprises two generally conical bearing surfaces (13), the cones defining the bearing surfaces having the same axis (A_{f}) forming an acute angle with the axis of the rolling surfaces, the core having a surface constituted by a spherical portion in f ront of each bearing.

2. Turbine according to claim 1, characterized in that it comprises two extending rollers (10) on either side of the core (8), on which notches (11) are made and which in each case have a wall (23) corresponding to one of the rolling surfaces.

3. Turbine according to claim 1, characterized in that the core is provided with two concavities (61), each of which is defined by one of the rolling surfaces (62).

4. Turbine according to any one of the claims 1 to 3, characterized in that the bearings comprise an annular bearing constituted by blowing nozzles (19) distributed over a circumference of the stator (2) between the bearing surfaces (13) and a bearing constituted by two blowing nozzles (15), each positioned along the axis (A_{f}) of one of the bearing surfaces (13).

5. Turbine according to any one of the claims 2 and 4,
characterized in that the core is constituted by two spherical cups (72), each located infront of one of the blowing nozzles (15) of the bearing surfaces and to each of which is connected a roller (10), as well as a truncated sphere (75) joining the two spherical cups and which has a smaller diameter than said spherical cups and which is positioned infront of the annular bearing.

6. Turbine according to claim 1 or 2, characterized in that the core (8) is spherical.

7. Turbine according to any one of the claims 1 to 6, characterized in that the cavity (9) is a volume of revolution, whose axis coincides with the axis of the rolling surfaces.

8. Turbine according to claims 6 and 7, characterized in that the core is notched (51) around the cavity (9).

9. Turbine according to claim 2, characterized in that the notches (11) are located at the ends of the rollers (10) opposite to the core.

10. Turbine according to any one of the claims 1 to 9, characterized in that the interior of the stator is under a vacuum.
